Europäisches Patentamt

European Patent Office

Office européen des brevets

(19)

(11) **EP 0 742 917 B1**

(12) **FASCICULE DE BREVET EUROPEEN**

(45) Date de publication et mention
de la délivrance du brevet:
**02.12.1998 Bulletin 1998/49**

(21) Numéro de dépôt: **95907724.9**

(22) Date de dépôt: **31.01.1995**

(51) Int Cl.⁶: **G06F 1/20**, G06F 1/32

(86) Numéro de dépôt international:
**PCT/FR95/00111**

(87) Numéro de publication internationale:
**WO 95/20786 (03.08.1995 Gazette 1995/33)**

(54) **PROCEDE ET DISPOSITIF DESTINE A REDUIRE LE NIVEAU SONORE D'UN MICRO-ORDINATEUR**

VERFAHREN UND VORRICHTUNG ZUR VERMINDERUNG DES RAUSCHPEGELS EINES MIKRORECHNERS

METHOD AND DEVICE FOR REDUCING THE NOISE LEVEL OF A MICROCOMPUTER

(84) Etats contractants désignés:
**AT BE CH DE DK ES GB GR IE IT LI LU MC NL PT SE**

(30) Priorité: **31.01.1994 FR 9401778**

(43) Date de publication de la demande:
**20.11.1996 Bulletin 1996/47**

(73) Titulaire: **Eynaud, Bruno**
**05000 Gap (FR)**

(72) Inventeur: **Eynaud, Bruno**
**05000 Gap (FR)**

(74) Mandataire: **Somnier, Jean-Louis et al**
**c/o Cabinet Beau de Loménie,**
**232, Avenue du Prado**
**13295 Marseille Cédex 08 (FR)**

(56) Documents cités:
**WO-A-89/06012**          **DE-U- 9 205 991**
**DE-U- 9 307 947**       **DE-U- 9 309 641**

- **RESEARCH DISCLOSURE, no.302, Juin 1989, HAVANT GB page 444 '30271 - Security Keybox for Workstation Keyboard'**
- **IBM TECHNICAL DISCLOSURE BULLETIN, vol.32, no.4B, Septembre 1989, NEW YORK US pages 60 - 61 'Automatic disk power reduction for portable computers'**
- **PATENT ABSTRACTS OF JAPAN vol. 015, no. 036 (E-1027) 29 Janvier 1991 & JP,A,02 273 476 (FUJITSU LTD) 7 Novembre 1990**

## Description

La présente invention concerne de façon générale un dispositif et un procédé destiné à réduire le niveau sonore d'un micro-ordinateur.

Dans la suite du texte, on utilisera essentiellement le mot "micro-ordinateur", par souci de clarté et de concision du texte, mais il est bien compris que le terme "micro-ordinateur" sera compris comme incluant toute machine du type ordinateur, calculateur, station de travail, machine de jeu ou spécialisée, ou autre, dès l'instant que ces machines incluent au moins un microprocesseur ou au moins un microprocesseur et une mémoire de masse à disque tournant.

Le niveau sonore d'un micro-ordinateur moderne a essentiellement pour origine, d'une part la rotation du disque dur du micro-ordinateur et d'autre part la rotation du ventilateur du micro-ordinateur.

Tant que les micro-ordinateurs étaient des machines utilisées principalement par des personnes agissant en tant que spécialistes ou que techniciens, ces personnes considéraient leur micro-ordinateur comme une machine "professionnelle" ou "industrielle" et elles ne considéraient pas comme d'une première exigence le fait que la machine soit très silencieuse. Cependant, les micro-ordinateurs modernes deviennent de plus en plus des appareils banalisés qui peuvent être présents dans des endroits très variés, à proximité de personnes dont les préoccupations professionnelles ou de loisir ne sont pas forcément directement liées à l'utilisation continuelle du micro-ordinateur situé à proximité. Il résulte de cela qu'il existe dans la pratique un grand nombre de situations dans lesquelles une personne se trouve à proximité d'un micro-ordinateur moderne qui est en marche, et cette personne subit consciemment ou inconsciemment le niveau sonore de ce micro-ordinateur. Le niveau sonore d'un micro-ordinateur moderne reste relativement faible mais cependant il se présente maintenant, du fait de la grande généralisation des micro-ordinateurs, un grand nombre de situations dans lesquelles une personne se trouve pendant un temps assez long dans un local dans lequel aucun objet ou appareil autre que le micro-ordinateur ne génère un niveau sonore significatif. Dans cette situation, le micro-ordinateur se trouve être le seul appareil à générer un bruit significatif et ceci constitue par conséquent une nuisance qui devient non négligeable.

Les micro-ordinateurs modernes, et plus particulièrement la plupart des micro-ordinateurs non portables constituent un parc de machines qui est devenu relativement grand. Même si l'on considère que ces micro-ordinateurs modernes non portables qui génèrent pratiquement tous un niveau sonore non négligeable sont des machines dont la durée de vie n'est pas excessivement grande, cette durée de vie est tout de même de plusieurs années, voire de plus de dix ans. Par conséquent, on peut considérer que, malgré une évolution probable des micro-ordinateurs non portables qui entraînera certains perfectionnements visant à rendre ces futurs micro-ordinateurs non portables plus silencieux, le parc des micro-ordinateurs non portables modernes actuel est suffisamment grand pour constituer en lui-même une demande pour un dispositif qui devrait pouvoir être facilement ajouté à un micro-ordinateur non portable existant afin de rendre ce micro-ordinateur plus silencieux.

Pour ce qui concerne les micro-ordinateurs futurs, leur conception devra inclure des perfectionnements visant à réduire le bruit de la machine. Un dispositif destiné à réduire le niveau sonore d'un micro-ordinateur selon la présente invention pourra aussi être inclus dans ces micro-ordinateurs futurs, soit lors de la fabrication de la machine soit après sa vente à un utilisateur final.

Des solutions techniques ont déjà été proposées, en particulier dans des micro-ordinateurs portables modernes, pour limiter au maximum la consommation d'énergie électrique. Par exemple, il est connu d'intégrer dans un micro-ordinateur portable un système permettant d'arrêter l'entraînement en rotation d'un disque à chaque fois que le micro-ordinateur est dans un état d'attente tout en étant en marche. Un tel système a été jusqu'à présent motivé principalement par le souci d'économiser de l'énergie électrique, et pour cette raison un tel système a été utilisé uniquement pour des micro-ordinateurs portables alimentés par batterie, mais il est incontestable qu'un tel système a permis en outre de diminuer le niveau sonore du micro-ordinateur à chaque fois que ce micro-ordinateur est dans une condition d'attente au cours de laquelle le disque ne tourne plus. Cependant, toutes les solutions techniques qui ont été adoptées pour un tel système inclus dans un micro-ordinateur portable ont été des solutions techniques passant par une intégration d'un circuit de commande d'entraînement du moteur du disque à l'intérieur d'une des cartes électroniques du micro-ordinateur, ce qui a eu pour conséquence que ce circuit a toujours fait partie intégrante du micro-ordinateur et qu'il a été toujours agencé lors de la fabrication du micro-ordinateur. Par conséquent, un tel circuit ne peut pas être utilisé tel quel pour être dans la pratique facilement rajoutable dans un micro-ordinateur existant afin de lui rajouter une fonctionnalité d'abaissement du niveau sonore par un arrêt conditionnel de la rotation du disque.

D'autres solutions techniques ont déjà été proposées, en particulier dans des mini-ordinateurs ou des micro-ordinateurs modernes, pour réguler la température interne de la machine. Par exemple, il est connu d'intégrer dans un ordinateur un système permettant de mettre en marche, d'arrêter et/ou d'entraîner à une vitesse modulée un moteur de ventilateur en vue d'adapter le débit de ventilation à la température interne moyenne de la machine. Un tel système a été jusqu'à présent motivé principalement par le souci d'empêcher un échauffement excessif d'au moins un composant interne de la machine, mais il est incontestable qu'un tel système a permis en outre de diminuer le niveau sonore de l'ordinateur à chaque fois que cet ordinateur est dans une condition de ventilation réduite ou d'absence de ventilation ainsi commandée. Cependant, toutes les solutions techniques qui ont été adoptées pour un tel système inclus dans un ordinateur ont été des solutions techniques passant par une intégration d'un circuit de commande d'entraînement du moteur de ventilateur à l'intérieur d'une des cartes électroniques de l'ordinateur se trouvant elle-même à l'intérieur d'un boîtier mécaniquement assemblé au micro-ordinateur, ce qui a eu pour conséquence que ce circuit a toujours fait partie intégrante de l'ordinateur et qu'il a été toujours agencé lors de la fabrication de l'ordinateur. Par conséquent, un tel circuit ne peut pas être utilisé tel quel pour être dans la pratique facilement rajoutable dans un micro-ordinateur existant (ne serait-ce que par la non normalisation des positions de fixation) afin de lui rajouter une fonctionnalité d'abaissement du niveau sonore par un arrêt conditionnel de la rotation du ventilateur et/ou une fonctionnalité de régulation thermique.

En outre, dans certains systèmes de régulation thermique connus, le capteur de température est disposé dans le flux d'air sortant, c'est-à-dire après être passé sur la majorité des composants de la machine et ceci permet d'obtenir une estimation globale de l'échauffement de la machine. Cette estimation globale a été longtemps suffisante mais actuellement elle n'est plus satisfaisante pour les raisons suivantes. Les ordinateurs ou micro-ordinateurs modernes ont une architecture du type "ouverte", c'est-à-dire que ces machines comportent lors de leur fabrication un certain nombre de cartes électroniques internes mais comportent également un certain nombre de logements vides destinés à recevoir ultérieurement des cartes électroniques supplémentaires destinées à procurer après coup à la machine certaines augmentations de capacité ou certaines fonctionnalités nouvelles non prévues initialement. Il résulte de cela que dans ces micro-ordinateurs modernes le système de régulation thermique classique tel que celui décrit précédemment peut être parfaitement adapté lors d'une configuration initiale de la machine mais peut se révéler inadapté lorsqu'une nouvelle carte électronique différente est rajoutée à l'intérieur de la machine. En effet, cette nouvelle carte électronique n'est pas obligatoirement conçue par le constructeur de la machine initiale et peut comporter des composants électroniques dont l'échauffement peut se révéler localement supérieur à un seuil considéré comme dangereux. En outre, ces cartes électroniques additionnelles sont conçues pour pouvoir être ajoutées indifféremment sur différentes sortes de micro-ordinateurs, mais il n'est pas toujours possible d'être certain qu'une même carte électronique additionnelle se comportera de la même façon du point de vue de l'échauffement d'au moins un de ses composants électroniques lorsque cette carte est montée sur un micro-ordinateur d'une sorte ou sur un micro-ordinateur d'une autre sorte, ce qui constitue un inconvénient majeur du point de vue de la fiabilité de fonctionnement de ces micro-ordinateurs modernes présentant une architecture du type "ouverte".

Afin de se prémunir de ce risque potentiel, ces systèmes de régulation thermique connus ne peuvent que réguler avec une marge de sécurité importante et donc avec une mauvaise efficacité en ce qui concerne la réduction des nuisances sonores.

Dans d'autres de ces systèmes de régulation thermique connus, un capteur de température est disposé tout près ou directement sur un composant susceptible de chauffer. Tant que la température détectée par le capteur est inférieure à un certain seuil, le ventilateur ne fonctionne pas ou fonctionne à vitesse réduite et, dès que température détectée par le capteur est supérieure au seuil, le ventilateur fonctionne à vitesse élevée.

Si le seuil prédéterminé est élevé (situé presque à la limite de température physiquement admissible pour le composant), le ventilateur doit augmenter très fortement sa vitesse lorsque ce seuil est dépassé afin de tenter de refroidir très énergiquement le composant avant qu'il ne se détériore. Il résulte de cela que le ventilateur doit être conçu de façon sur-dimensionnée pour pouvoir fournir (rarement) une puissance de refroidissement très grande, ce qui est un inconvénient du point de vue du coût et du point de vue du bruit élevé susceptible de survenir (bien que rarement). Psychologiquement et physiologiquement, un bruit très fort survenant rarement est perçu comme une nuisance importante.

Si le seuil prédéterminé est bas (situé très en dessous de la limite de température physiquement admissible pour le composant), le ventilateur peut être conçu de façon faiblement dimensionnée afin de fonctionner à une vitesse maximum relativement faible parce que le composant sera refroidi plus tôt, de façon anticipée. Par contre, le ventilateur se mettra en marche très souvent, par exemple plusieurs fois par minute ou par heure. Il résulte de cela que le ventilateur change fréquemment et brusquement de vitesse et donc de niveaux sonores, et ceci crée une nuisance sonore importante. Psychologiquement et physiologiquement, un bruit faible mais survenant fréquemment est perçu comme une nuisance importante.

On peut remarquer que, dans ce cas, l'augmentation de la régularité de fonctionnement ne peut être obtenue qu'en relevant le régime réduit afin d'être capable de maintenir la température du composant à ce niveau bas et donc en augmentant le niveau sonore de base.

On est donc obligé de choisir entre :

- quelques bruits très intenses apparaissant brusquement dans le silence (dans ce cas, les composants sont soumis à des contraintes thermiques importantes et l'utilisateur est soumis à des contraintes psychologiques et physiologiques importantes ;
- des augmentations de bruit plus modérées (mais bien perceptibles) et fréquentes (dans ce cas, l'attention de l'utilisateur est fréquemment attirée, ce qui nuit à la continuité de sa concentration) ;

- un bruit plus régulier et plus élevé que dans le cas précédent (bruit qui, s'il est presque constant, va, selon des études médicales connues, s'il est supérieur à 50 dB, induire insidieusement et verrouiller une fatigue généralisée chez l'utilisateur par effet d'accumulation physiologique).

DE-U-92 05 991 (WEINFURTER) décrit un dispositif/procédé pour réduire le niveau sonore d'un ordinateur,
l'ordinateur incluant

- un ventilateur entraîné en rotation par un moteur de ventilation, au moins un composant dégageant de la chaleur, une première source d'alimentation pour alimenter en courant électrique le moteur de ventilation directement via un premier câble électrique,
- une unité du premier type incluant des contacts d'entrée et de sortie étant connecté de façon intercalaire sur le premier câble et qui inclut:

des moyens alimentés par la première alimentation et qui reçoivent via au moins un câble de signal de température au moins un signal de température produit par au moins un capteur situé à une certaine distance du dit composant et qui fonctionnent de façon à établir ou moduler de façon sélective l'alimentation du moteur de ventilateur via les contacts d'entrées et de sortie de l'unité de premier type, qui modulent l'alimentation du moteur selon une loi mathématique prédéterminée en fonction du dit au moins un signal de température;
ledit au moins un signal de température destiné à être installé dans ledit ordinateur.

DE-U-93 07 947 (REINERS) décrit un dispositif pour réduire le niveau sonore d'un ordinateur incluant un ventilateur entraîné par un moteur de ventilateur, le dispositif comportant une unité de premier type se coinçant entre une première source d'alimentation et le moteur de ventilateur et qui dès que la température à l'intérieur de l'ordinateur dépasse une certaine température excessive provoque l'alimentation du moteur et lorsque une deuxième température est alors atteinte après peu de temps provoque la coupure de l'alimentation du moteur.

Dans IBM TECHNICAL DISCLOSURE BULLETIN, vol. 32, no. 4B, Septembre 1989, NEW YORK, US, pages 60-61, 'Automatic disk power reduction for portable computers', l'alimentation (d'un disque) est coupée et établie en fonction d'un signal (de commande) par un premier circuit de modulation d'alimentation commandé par un circuit de pilotage recevant le signal.

De WO-A-89 06012 (RAKOCZY), il est connu de connecter une unité du second type entre un disque et une source d'alimentation.

Dans DE-U- 93 09 641 (GEISS), une unité de premier type, incluant contacts d'entrée et de sortie est destinée à pouvoir se connecter de façon intercalaire et amovible sur un câble reliant une source d'alimentation à un moniteur, cette unité étant commandée par un signal de commande d'un ordinateur de façon à moduler l'alimentation du moniteur.

Un objet de la présente invention consiste à proposer un dispositif nouveau pour réduire le niveau sonore d'un micro-ordinateur existant.

Un autre objet de l'invention consiste à proposer un tel dispositif permettant en outre d'être facilement installé sur une grande variété de micro-ordinateurs existants réalisés par des constructeurs différents.

Un autre objet de l'invention consiste à proposer un tel dispositif permettant en outre d'augmenter la fiabilité du micro-ordinateur existant par une amélioration de son système de refroidissement, cette amélioration du système de refroidissement résultant directement du fonctionnement nouveau du dispositif.

Un autre objet de l'invention consiste à proposer un tel dispositif permettant en outre de réduire la consommation d'énergie du micro-ordinateur existant.

Selon l'invention, il est proposé un procédé pour réduire le niveau sonore d'un micro-ordinateur comme défini dans la revendication 10.

Selon un mode de réalisation, ladite étape (c) de positionnement dudit au moins un premier capteur de température consiste à positionner ledit au moins un capteur de température en amont dudit au moins un composant dégageant de la chaleur, par rapport à la direction d'écoulement, obtenu par convection naturelle ou par ventilation forcée de non proximité, d'un air de refroidissement du composant, la distance séparant ledit premier capteur et ledit composant étant comprise entre 5 mm et 20 mm.

Selon un autre mode de réalisation, ladite étape (c) de positionnement dudit au moins un premier capteur de température consiste à positionner ledit au moins un capteur de température en amont dudit au moins un composant dégageant de la chaleur, par rapport à la direction d'écoulement, obtenu par ventilation forcée provoquée par un ventilateur de proximité agencé spécifiquement pour ce composant et situé très près de lui, d'un air de refroidissement du composant, la distance séparant ledit premier capteur et ledit ventilateur de proximité étant comprise entre 0 mm et 10 mm.

Selon un autre mode de réalisation, ladite étape (c) de positionnement dudit au moins un capteur de température consiste à positionner en outre un autre capteur de température dans le flux d'un air de refroidissement à l'endroit où cet air sort du micro-ordinateur après avoir balayé un ensemble de composants du micro-ordinateur et donc après avoir été réchauffé du fait de l'apport de chaleur cumulé de cet ensemble de composants.

Selon un autre mode de réalisation, un dit ventilateur est commandé de façon à augmenter sa vitesse lorsque ledit premier capteur détecte une température supérieure à un premier seuil prédéterminé ou lorsque ledit autre capteur détecte une température supérieure à un autre seuil prédéterminé, cette condition "ou" étant une fonction logique "ou inclusif".

Selon un autre mode de réalisation, dans lequel ledit micro-ordinateur inclut en outre, entre autre :

au moins un disque (2) entraîné en rotation par un moteur de disque, au moins un circuit électrique comportant au moins une borne de sortie produisant un signal de requête de fonctionnement d'un disque, une seconde source d'alimentation pour alimenter en courant électrique le un moteur de disque, un troisième câble électrique reliant la seconde source d'alimentation au moteur de disque soit directement soit via un troisième élément de connexion et via un quatrième élément de connexion enfichable de façon amovible sur le troisième élément de connexion et raccordé au moteur de disque ;

le procédé est caractérisé en ce que ladite étape (a) comprend en outre :

l'agencement d'au moins une unité de second type incluant des contacts d'entrée et de sortie, qui est destinée à pouvoir se connecter de façon intercalaire et amovible soit sur le second câble soit entre le troisième élément de connexion et le quatrième élément de connexion et qui inclut :

un second circuit de modulation d'alimentation (46) commandé en fonction d'un signal de commande de façon à couper, établir ou moduler de façon sélective l'alimentation électrique pour le moteur de disque via certains contacts d'entrée et de sortie de l'unité de second type, et

un second circuit de pilotage qui est alimenté en permanence par la seconde alimentation via les contacts d'entrée de l'unité de second type, qui reçoit ledit signal de requête de fonctionnement via un câble de signal de requête de fonctionnement et qui produit en sortie ledit signal de commande pour commander le second composant de modulation d'alimentation, de telle sorte que le signal de commande provoque l'alimentation du moteur de disque pendant tout le temps où le signal de requête de fonctionnement est dans un état signifiant une requête de fonctionnement et provoque la coupure ou l'abaissement de l'alimentation du moteur de disque lorsque le signal de requête de fonctionnement est resté dans un état signifiant une absence de requête de fonctionnement pendant une durée dépassant une valeur prédéterminée, ajustable par l'utilisateur, ou automatiquement ajustable;

et en ce qu'il comprend en outre les étapes :

(d) le branchement de l'au moins une unité de second type sur l'au moins un second câble en sectionnant celui-ci totalement ou partiellement ou le branchement de ladite unité de second type entre les troisième et quatrième éléments de connexion ; et

(e) l'insertion de l'au moins un connecteur de signal de requête de fonctionnement destiné à l'au moins une unité de second type.

Selon un autre mode de réalisation, il est proposé un dispositif pour réduire le niveau sonore d'un micro-ordinateur comme défini dans la revendication 1.

Selon un autre mode de réalisation, ledit au moins un premier capteur de température est positionné en amont dudit au moins un composant dégageant de la chaleur, par rapport à la direction d'écoulement, obtenu par convection naturelle ou par ventilation forcée de non proximité, d'un air de refroidissement du composant, la distance séparant ledit premier capteur et ledit composant étant comprise entre 5 mm et 20 mm.

Selon un autre mode de réalisation, ledit au moins un premier capteur de température est positionné en amont dudit au moins un composant dégageant de la chaleur, par rapport à la direction d'écoulement, obtenu par ventilation forcée provoquée par un ventilateur de proximité agencé spécifiquement pour ce composant et situé très près de lui, d'un air de refroidissement du composant, la distance séparant ledit premier capteur et ledit ventilateur de proximité étant comprise entre 0 mm et 10 mm.

Selon un autre mode de réalisation, un autre capteur de température est positionné dans le flux d'un air de refroidissement à l'endroit où cet air sort du micro-ordinateur après avoir balayé un ensemble de composants du micro-ordinateur et donc après avoir été réchauffé du fait de l'apport de chaleur cumulé de cet ensemble de composants.

Selon un autre mode de réalisation, un dit ventilateur est commandé de façon à augmenter sa vitesse lorsque ledit premier capteur détecte une température supérieure à un premier seuil prédéterminé ou lorsque ledit autre capteur détecte une température supérieure à un autre seuil prédéterminé, cette condition "ou" étant une fonction logique "ou inclusif".

Selon un autre mode de réalisation, ledit micro-ordinateur inclut en outre, entre autre :

au moins un disque entraîné en rotation par un moteur de disque, au moins un circuit électrique comportant au moins une borne de sortie produisant un signal de requête de fonctionnement d'un disque, une seconde source d'alimentation pour alimenter en courant électrique le un moteur de disque, un troisième câble électrique reliant la seconde source d'alimentation au moteur de disque soit directement soit via un troisième élément de connexion (16) et via un quatrième élément de connexion enfichable de façon amovible sur le troisième élément de connexion et raccordé au moteur de disque ;

le dispositif étant caractérisé en ce qu'il comprend en outre

au moins une unité de second type (31) incluant des contacts d'entrée et de sortie, qui est destinée à pouvoir se connecter de façon intercalaire et amovible soit sur le second câble soit entre le troisième élément de connexion et le quatrième élément de connexion et qui inclut :

un second circuit de modulation d'alimentation (46) commandé en fonction d'un signal de commande de façon à couper, établir ou moduler de façon sélective l'alimentation électrique pour le moteur de disque via certains contacts d'entrée et de sortie de l'unité de second type, et

un second circuit de pilotage qui est alimenté en permanence par la seconde alimentation via les contacts d'entrée de l'unité de second type, qui reçoit ledit signal de requête de fonctionnement via un câble de signal de requête de fonctionnement et qui produit en sortie ledit signal de commande pour commander le second composant de modulation d'alimentation, de telle sorte que le signal de commande provoque l'alimentation du moteur de disque pendant tout le temps où le signal de requête de fonctionnement est dans un état signifiant une requête de fonctionnement et provoque la coupure ou l'abaissement de l'alimentation du moteur de disque lorsque le signal de requête de fonctionnement est resté dans un état signifiant une absence de requête de fonctionnement pendant une durée dépassant une valeur prédéterminée, ajustable par l'utilisateur, ou automatiquement ajustable ;

l'au moins une unité de second type étant branchée sur l'au moins un second câble en sectionnant celui-ci totalement ou partiellement ou branchée entre les troisième et quatrième éléments de connexion.

Selon un autre mode de réalisation, ledit second circuit de pilotage reçoit ledit signal de requête de fonctionnement via ledit câble de signal de requête de fonctionnement et via un connecteur connectable à un élément de connexion existant initialement dans le micro-ordinateur.

Selon un autre mode de réalisation, ladite unité de second type et ladite unité de premier type sont disposées chacune en au moins un exemplaire dans un emballage unique afin de constituer ledit dispositif sous forme d'un kit destiné à être utilisé pour réduire le niveau sonore d'un micro-ordinateur.

Selon un autre mode de réalisation, ladite unité de second type est disposée en une pluralité d'exemplaires dans ledit emballage unique, ces exemplaires différant les uns des autres par la forme desdits contacts d'entrée et de sortie de façon à ce que cette pluralité d'exemplaires couvre une pluralité de types standards différents possibles pour lesdits troisième et quatrième éléments de connexion.

Selon un autre mode de réalisation, ladite unité de premier type est disposée en une pluralité d'exemplaires dans ledit emballage unique, ces exemplaires différant les uns des autres par la forme desdits contacts d'entrée et de sortie de façon à ce que cette pluralité d'exemplaires couvre une pluralité de types standards différents possibles pour lesdits premier et deuxième éléments de connexion.

Selon un autre mode de réalisation, ladite unité de second type est réalisée en un boîtier en plastique moulé supportant au niveau de deux faces opposées respectivement lesdits contacts d'entrée et de sortie et enfermant à la fois ledit second circuit de modulation d'alimentation de commande, ledit second circuit de pilotage et différentes connexions électriques établies entre ces composants et ces contacts d'entrée et de sortie.

Selon un autre mode de réalisation, ladite unité de premier type est réalisée en un boîtier en plastique moulé supportant au niveau de deux faces opposées respectivement lesdits contacts d'entrée et de sortie et enfermant à la fois ledit premier circuit de modulation d'alimentation, ledit premier circuit de pilotage et différentes connexions électriques établies entre ces composants et ces contacts d'entrée et de sortie.

Ces objets, caractéristiques et avantages, ainsi que d'autres de la présente invention seront mieux compris lors de la description détaillée d'un exemple de réalisation qui va suivre, illustrée par les figures annexées parmi lesquelles :

la figure 1 est une vue générale simplifiée et en perspective des éléments essentiels contenus dans un micro-ordinateur moderne de l'art antérieur ;
la figure 2 est une vue semblable à celle de la figure 1 du même micro-ordinateur mais dans lequel un dispositif selon la présente invention est ajouté ;
la figure 3 est une vue en coupe simplifiée d'une réalisation d'un premier élément essentiel (unité de type 1) du dispositif selon la présente invention ;
la figure 4 est une vue semblable à celle de la figure 3 mais concernant une variante de réalisation du premier élément essentiel (unité de type 1) du dispositif selon la présente invention ;
la figure 5 est une vue en coupe simplifiée d'une réalisation d'un second élément essentiel (unité de type 2) du dispositif selon la présente invention ;
la figure 6 est une vue semblable à celle de la figure 5 mais concernant une variante de réalisation du second élément essentiel (unité de type 2) du dispositif selon la présente invention ;
la figure 7 est un organigramme illustrant le fonctionnement d'une subroutine utilisable dans le micro-ordinateur dans lequel est installé le dispositif selon la présente invention afin d'améliorer son fonctionnement ;

la figure 8 est une vue de côté simplifiée de l'intérieur d'un micro-ordinateur, destinée à montrer un emplacement d'un capteur de température, emplacement déterminé selon un autre aspect de la présente invention ;

la figure 9 est une vue de côté simplifiée de l'intérieur d'un micro-ordinateur, destinée à montrer un autre emplacement d'un capteur de température, emplacement déterminé selon encore un autre aspect de la présente invention ; et

la figure 10 représente en perspective un mode de réalisation préféré d'une unité selon la présente invention.

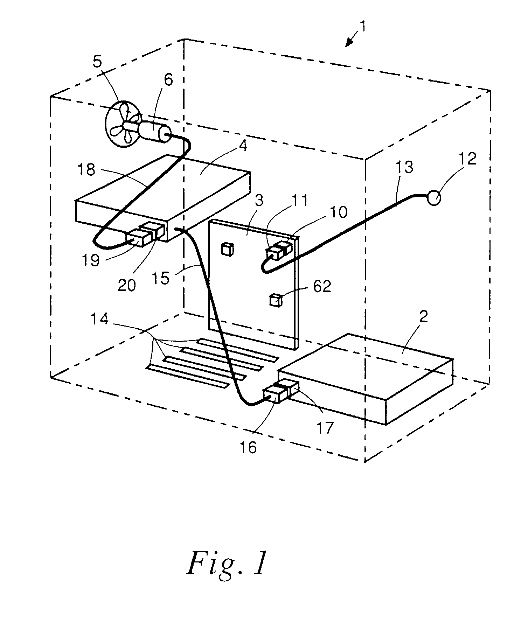

Sur la figure 1, on distingue d'une façon schématique et partielle, un micro-ordinateur existant moderne 1. Plus exactement, on distingue en traits mixtes les contours externes parallélépipédiques d'un tel micro-ordinateur. Le micro-ordinateur 1 inclut à l'intérieur un grand nombre d'éléments classiques qui ne seront pas décrits ici par souci de simplification, mais parmi ces éléments classiques, il convient de signaler certains éléments qui doivent être pris en compte pour la compréhension de l'invention. Parmi ces éléments, on trouve une unité de disque dur 2, qui inclut classiquement un disque dur (non représenté) et un moteur de disque dur (non représenté), une carte électronique 3, une source d'alimentation 4, un ventilateur 5 et un moteur de ventilateur 6. La carte électronique 3 comporte entre autres un connecteur mâle 10 auquel peut être raccordé un connecteur femelle 11 qui est relié à une diode électroluminescente 12 via un câble 13. Un signal électrique est produit dans des broches du connecteur 10 et il est transmis via le connecteur 11 et le câble 13 à la diode électroluminescente 12. Ce signal électrique constitue un signal de requête de fonctionnement du disque dur. En d'autres termes, lorsque la carte électronique 3 souhaite accéder à des informations contenues dans le disque dur 2, elle émet le signal de requête de fonctionnement du disque dur de façon à déclencher à la fois l'allumage de la diode électroluminescente 12 et un processus de communication d'informations entre la carte 3 et le disque dur 2. La diode électroluminescente 12 sert à signaler à un utilisateur que le disque dur 2 est en cours d'utilisation lorsque la diode électroluminescente est allumée. Dans la réalité, il existe généralement plus d'une carte électronique 3 mais une seule est représentée ici par souci de simplification, et en outre il existe des connecteurs destinés à pouvoir recevoir d'autres cartes électroniques qui peuvent être de types différents et qui sont destinées à être raccordées ultérieurement en étant logées dans le micro-ordinateur en vue de modifier ses fonctionnalités ou d'augmenter ses performances. Ces cartes électroniques supplémentaires rajoutables ne sont pas représentées ici par souci de simplification. On a cependant représenté en 14 plusieurs connecteurs destinés à recevoir de telles cartes supplémentaires. L'alimentation 4 alimente en courant électrique le disque dur 2 par l'intermédiaire d'un câble 15 dont l'extrémité libre est raccordée à un connecteur femelle 16 connectable à un connecteur mâle 17 branché sur le disque dur 2. D'une façon similaire, l'alimentation 4 alimente en courant électrique le moteur de ventilateur 6 par l'intermédiaire d'un câble 18 dont l'extrémité libre est raccordée à un connecteur femelle 19 connectable à un connecteur mâle 20 branché directement sur un circuit imprimé (non représenté) de l'alimentation 4.

La carte électronique 3, ainsi que les autres cartes électroniques qui sont présentes dans le micro-ordinateur ou les cartes électroniques supplémentaires qui peuvent être rajoutées par la suite, comportent généralement un certain nombre de composants électroniques ou d'appareils électriques qui dégagent de la chaleur selon une puissance calorifique qui varie en fonction des conditions de fonctionnement de ces composants. A titre d'exemple, et par souci de simplification, on a représenté un seul de ces composants électroniques à l'aide de l'index de référence 62. Bien entendu, d'autres éléments ou d'autres appareils présents dans l'ordinateur mais non installés sur les cartes électroniques 3 peuvent constituer aussi des sources de chaleur, comme par exemple l'alimentation 4. Dans un tel micro-ordinateur moderne existant 1, le ventilateur 5 et le disque dur 2 sont généralement tous les deux entraînés en rotation d'une façon continue pendant tout le temps où le micro-ordinateur est en marche. Par conséquent, il existe dans un tel micro-ordinateur 1 pratiquement deux seules sources sonores, à savoir le ventilateur 5 et le disque dur 2. En général, tous les autres appareils contenus dans le micro-ordinateur sont statiques et ne génèrent pratiquement aucun bruit. Le dispositif selon la présente invention est destiné à pouvoir être facilement rajouté à un tel micro-ordinateur moderne existant 1 de façon à pouvoir rendre silencieux un tel micro-ordinateur pendant la plus grande partie du temps au cours duquel ce micro-ordinateur est en marche. En effet, un tel micro-ordinateur 1 est généralement utilisé d'une façon qui peut être très épisodique au cours d'une journée tandis qu'il reste en marche pratiquement pendant toute la journée ou au moins pendant plusieurs heures pour des raisons qui sont essentiellement liées au fait qu'il est d'une part nuisible de mettre en route et d'arrêter trop souvent un micro-ordinateur et qu'il se produit d'autre part une perte de temps relativement importante à chaque fois que l'on remet en route l'ordinateur. Par contre, il arrive très fréquemment et de plus en plus qu'un tel micro-ordinateur 1 fonctionne statistiquement relativement peu de temps par rapport au temps total durant lequel il est en marche et, pendant ce faible temps au cours duquel il fonctionne effectivement, le temps pendant lequel il a besoin pour fonctionner de la mise en route effective du disque dur est un temps encore plus faible. Par ailleurs, le ventilateur 5 est généralement toujours en marche dans un tel micro-ordinateur moderne existant 1, alors qu'en réalité son fonctionnement à régime maximal est superflu pendant la majeure partie du temps au cours duquel le micro-ordinateur est en marche.

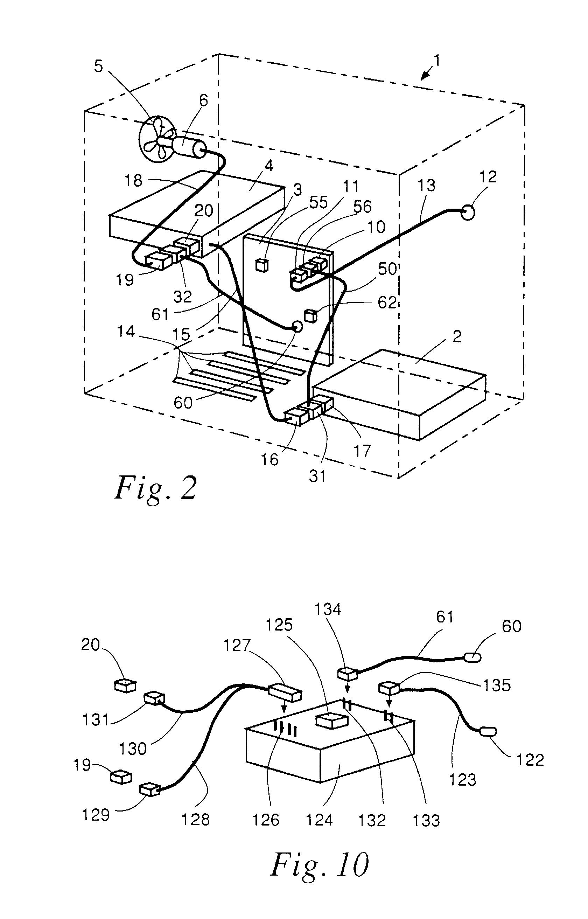

Le dispositif selon la présente invention, agencé ou non sous forme d'un kit, est essentiellement constitué par des unités de deux types, n unités de type 1 et p unités de type 2 (n≥1 et p≥1). Ce dispositif selon la présente invention va être décrit maintenant en relation avec la figure 2 qui illustre le cas d'un dispositif incluant seulement une unité de type 1 et une unité de type 2. Sur la figure 2, on distingue le même micro-ordinateur moderne existant 1 que celui qui a été décrit en relation avec la figure 1. Le dispositif selon la présente invention est composé d'un certain nombre d'éléments qui sont généralement rassemblés sous forme d'un kit, ce kit étant destiné à être mis à la disposition d'un utilisateur d'un tel micro-ordinateur 1 ou d'un professionnel chargé de la commercialisation ou de la maintenance d'un tel micro-ordinateur 1. Ce kit est alors utilisé par l'une quelconque de ces personnes pour être ajouté dans le micro-ordinateur moderne existant 1 afin de le rendre beaucoup plus silencieux. Ce kit permet en outre d'améliorer la fiabilité du fonctionnement d'un tel micro-ordinateur 1 comme cela sera expliqué par la suite.

Sur la figure 2, le dispositif selon la présente invention, agencé ou non sous forme d'un kit, est essentiellement constitué par une unité de type 1 et une unité de type 2. Une unité de type 1 est destinée à pouvoir se connecter de façon intercalaire et amovible soit sur le câble 15, soit entre le connecteur femelle 16 et le connecteur mâle 17, qui ont été décrits précédemment pour commander le moteur du disque dur. L'unité de type 2 est destinée à pouvoir se connecter de façon intercalaire et amovible soit sur le câble 18, soit entre le connecteur femelle 19 et le connecteur mâle 20, pour commander le moteur de ventilateur.

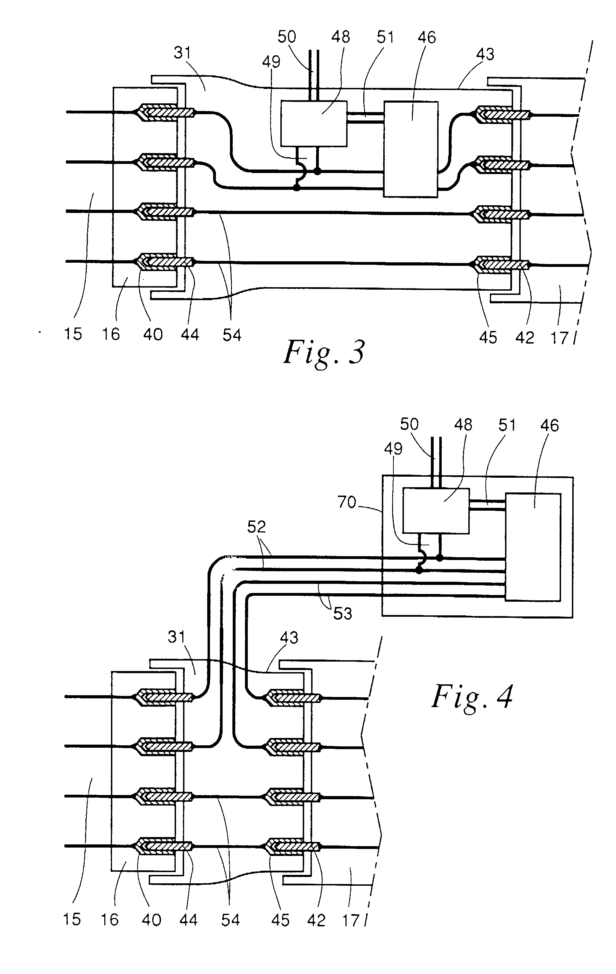

Un premier mode de réalisation peut être celui où l'unité de type 1 prend la forme d'une prise gigogne 31 qui se connecte entre le connecteur femelle 16 et le connecteur mâle 17 et où l'unité de type 2 prend la forme d'une prise gigogne 32 qui se connecte entre le connecteur femelle 19 et le connecteur mâle 20. Autrement dit, une personne qui souhaite rendre plus silencieux et plus fiable un micro-ordinateur moderne existant 1 commence par ouvrir un ou plusieurs capots du micro-ordinateur pour pouvoir accéder à l'intérieur, puis elle débranche les connecteurs femelle et mâle 16 et 17 normalement raccordés ensemble, elle y intercale la première prise gigogne 31 et elle raccorde l'ensemble ainsi constitué, puis elle insère la prise d'information 56 entre le connecteur femelle 11 et le connecteur mâle 10, et ensuite elle opère de la même façon pour raccorder ensemble la prise gigogne 32 et les connecteurs femelle et mâle 19 et 20 puis elle positionne et fixe le (ou les) capteur(s) de température 60 situé à l'extrémité du ou des câbles 61. La structure et le fonctionnement de la prise gigogne 31 et la structure et le fonctionnement de la prise gigogne différente 32 vont être décrits et expliqués maintenant en se rapportant aux figures 3 à 6.

Sur la figure 3, on distingue un exemple de réalisation de la prise gigogne 31 qui est connectée entre le connecteur femelle 16 et le connecteur mâle 17. Ce connecteur femelle 16, auquel est raccordé le câble 15 qui provient de l'alimentation 4, comporte un certain nombre de contacts femelles 40 dont le nombre peut être limité à deux mais qui peuvent être en un nombre plus grand. Le connecteur mâle 17 est raccordé directement à un circuit imprimé (non représenté) destiné au pilotage du moteur d'entraînement du disque dur 2 (non représenté) et ce connecteur mâle 17 comporte des contacts mâles 42 dont le nombre peut être limité à deux mais qui peuvent être en un nombre supérieur. Lorsque le micro-ordinateur 1 est agencé d'une façon initiale classique, c'est-à-dire sans l'adjonction du dispositif selon la présente invention, le connecteur femelle 16 est directement raccordé au connecteur mâle 17 de telle sorte que les contacts femelles 40 s'emboîtent respectivement dans les contacts mâles 42 correspondants. Lorsque l'utilisateur rajoute au micro-ordinateur 1 le dispositif selon la présente invention, il déconnecte les connecteurs 16 et 17 et intercale la prise gigogne 31. La prise gigogne 31 se présente de façon générale sous la forme d'un boîtier en matière plastique 43 qui comporte sur une face des contacts mâles 44 et sur la face opposée des contacts femelles 45. On comprend alors que l'on peut aisément raccorder en série le connecteur femelle 16, la prise gigogne 31 et le connecteur mâle 17. Le boîtier 43 de la prise gigogne 31 inclut un circuit de modulation d'alimentation 46 qui peut être soit un interrupteur tout ou rien, soit un interrupteur tout ou peu, soit un variateur de tension analogique commandable, soit un convertisseur continu/continu commandable, etc. L'alimentation présente sur au moins deux des contacts mâles 44 reliés aux connexions électriques 52 est transmise ou convertie via les connexions électriques 53 aux connecteurs femelles 45 correspondants par le circuit de modulation d'alimentation 46. Les autres contacts mâles 44, s'il y en a, sont reliés directement via les connexions électriques 54 aux contacts femelles 45 leur correspondant. Dans un mode de réalisation pratique, le circuit de modulation d'alimentation 46 peut être réalisé en employant un relais électromécanique ou, de préférence, en employant un (ou des) composant(s) électronique(s) actif(s) tels que des transistors de puissance. La prise gigogne 31 comporte en outre un circuit de pilotage 48 qui est alimenté en permanence par du courant électrique grâce à des connexions électriques 49 raccordées aux connexions électriques 52. Puisque le câble 15 provient d'une alimentation en courant électrique 4 (décrite précédemment), le potentiel électrique qui est présent en permanence entre certains conducteurs du câble 15 pendant tout le temps où le micro-ordinateur 1 est en marche, est transmis au circuit de pilotage 48 via les contacts femelles 40, les contacts mâles 44 et les connexions électriques 52 et 49. Par conséquent, pendant tout le temps où le micro-ordinateur 1 est en marche, le circuit de pilotage 48 est alimenté et peut fonctionner normalement. Un autre câble 50 vient également se raccorder au circuit de pilotage 48 et le circuit de pilotage 48 est en outre connecté via une connexion 51 au circuit de modulation d'alimentation 46 afin de commander celui-ci. Si l'on se reporte à nouveau à la figure 2, on voit que le câble 50, qui permet d'amener le signal de requête de fonctionnement du disque dur jusqu'au circuit de pilotage 48 de la prise gigogne 31, est un câble qui comporte au niveau de son extrémité opposée à celle de la prise gigogne 31 une prise gigogne 56. Cette prise gigogne 56 est destinée à venir s'intercaler entre le connecteur femelle 11 et le connecteur mâle 10 (décrits précédemment) qui sont normalement raccordés ensemble pour permettre l'alimentation de la diode électroluminescente 12.

La prise gigogne 31 fonctionne de la façon qui est décrite maintenant en se reportant à la fois à la figure 2 et à la figure 3. Lorsque le micro-ordinateur 1 est en marche, la carte électronique 3 fonctionne et, pendant un instant particulier de son fonctionnement, cette carte électronique 3 doit échanger des informations avec le disque dur 2 et, pour cela, elle émet un signal électrique de requête de fonctionnement du disque dur au niveau de son connecteur 10. Une liaison électrique est établie entre ce connecteur 10 et la prise gigogne 31, cette connexion utilisant le câble 50 décrit précédemment. Par conséquent, le circuit de pilotage 48 reçoit un tel signal de requête de fonctionnement de disque dur via le câble 50 et il produit alors un signal qui est envoyé dans la connexion 51 afin de commander le circuit de modulation d'alimentation 46 de façon à ce qu'il établisse une condition passante afin de faire en sorte que, via les connexions électriques 52 et 53, le courant électrique provenant de l'alimentation 4 via le câble 15 soit transmis électriquement jusqu'au moteur de disque dur afin de faire tourner le disque dur.

Ensuite, le circuit de pilotage 48 commande la poursuite de l'alimentation du moteur du disque dur 2 jusqu'à l'expiration d'un délai d'arrêt. Quand le signal transmis par le câble 50 correspond à une requête de fonctionnement du disque dur, le délai d'arrêt est suspendu et ré-initialisé à une valeur prédéterminée ou ajustable par l'utilisateur, ou automatiquement ajustable. A l'expiration du délai d'arrêt, le moteur du disque dur est soit progressivement, soit brutalement amené jusqu'à l'arrêt complet ou jusqu'à une vitesse réduite.

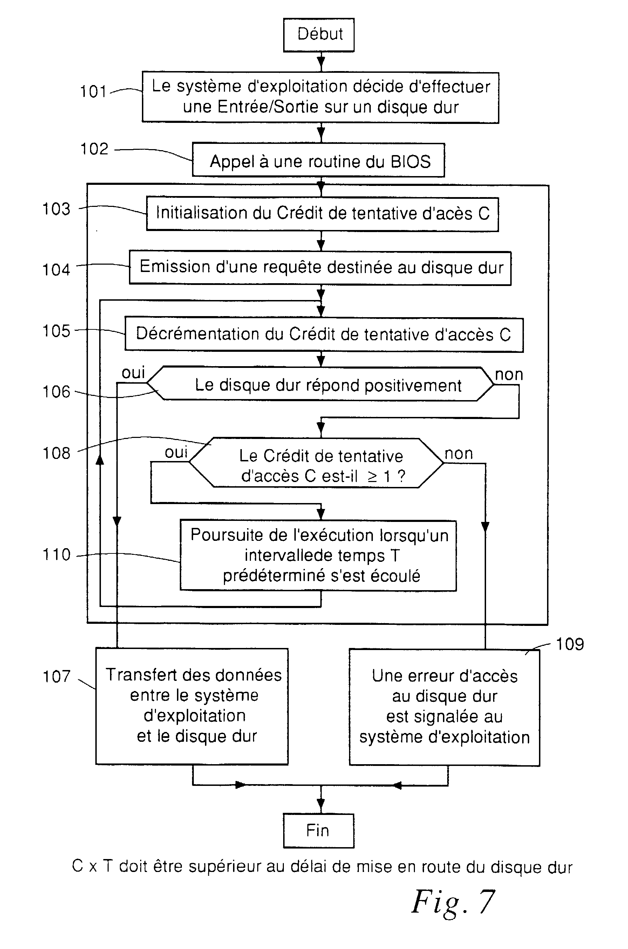

Selon une variante de réalisation, la commande de l'alimentation du moteur du disque dur 2 est associée à un mode particulier d'entrée/sortie plus perfectionné tel que représenté dans l'organigramme de la figure 7. Dans cet organigramme, il faut préciser que le terme BIOS signifie un programme résident qui est généralement contenu dans une mémoire non volatile (ROM) (représentée par l'index de référence 55 sur les figures 1 et 2), ce programme permettant de gérer les interactions entre le système d'exploitation du micro-ordinateur 1 et l'ensemble du matériel qui constitue ce micro-ordinateur. Il existe en général un BIOS dans un micro-ordinateur moderne moderne 1, ce BIOS étant contenu dans une ROM 55, mais ce BIOS peut être changé par un BIOS spécifique permettant de mettre en oeuvre le mode de fonctionnement particulier tel que représenté sur l'organigramme de la figure 7 lorsque le dispositif selon la présente invention est ajouté au micro-ordinateur existant 1. Pour remplacer le BIOS initial par un nouveau BIOS spécifique, il suffit que le kit qui inclut les unités de type 1 et de type 2 comprenne en outre une nouvelle ROM BIOS qui peut être facilement utilisée pour venir remplacer la ROM BIOS 55 initialement prévue dans le micro-ordinateur existant 1, cette opération étant simplifiée par le fait qu'en général les ROM contenant le BIOS sont connectées de façon amovible sur des connecteurs appropriés qui sont eux-mêmes soudés sur les cartes électroniques contenues dans le micro-ordinateur.

Dans cet organigramme, on voit qu'un programme du micro-ordinateur commence par une condition dans laquelle "le système d'exploitation décide d'effectuer une Entrée/Sortie sur un disque dur" (étape 101). Ensuite, il effectue un "appel à une routine du BIOS" (étape 102). Ensuite, il "initialise le Crédit de tentative d'accès C" (étape 103). Ensuite, il effectue "l'émission d'une requête destinée au disque dur" (étape 104). Ensuite, il "décrémente le Crédit de tentative d'accès C" (étape 105). Ensuite il pose la question "le disque dur répond-il positivement ?" (étape 106); si la réponse est oui, il va à une instruction "transfert des données entre le système d'exploitation et le disque dur" (étape 107) puis à une fin ; si la réponse est non, il passe à la question "le Crédit de tentative d'accès C est-il supérieur ou égal à 1 ?" (étape 108) ; si la réponse est non, il va à une instruction de message "une erreur d'accès su disque dur est signalée" (étape 109) puis à une fin'; et si la réponse est oui, il effectue une "poursuite de l'exécution lorsqu'un intervalle temps T prédéterminé s'est écoulé" (étape 110), puis il revient à l'instruction "décrémentation du Crédit de tentative d'accès C" (étape 105). Il faut préciser que la condition suivante doit être respectée :

$$C \times T \geq \text{délai de mise en route du disque dur.}$$

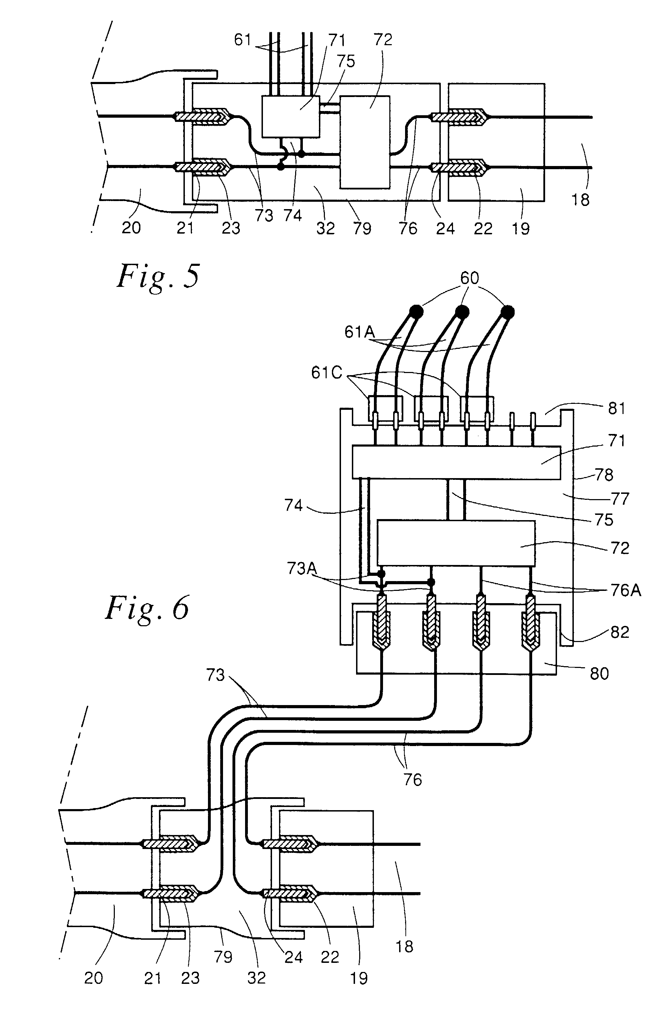

Sur la figure 5, on distingue un exemple de réalisation de la prise gigogne 32 qui est connectée entre le connecteur mâle 20 et le connecteur femelle 19. La structure interne de la prise gigogne 32 est similaire à celle de la prise gigogne 31. Par conséquent, la prise gigogne 32 comprend pareillement un boîtier 79 renfermant des contacts femelles 23, des contacts mâles 24, un circuit de modulation d'alimentation 72 et un circuit de pilotage 71. Comme on peut le voir sur la figure 2, la prise gigogne 32 est connectée entre les connecteurs 19 et 20 de façon à ce que son circuit de modulation d'alimentation puisse couper ou établir ou moduler de façon sélective l'alimentation du moteur de ventilateur 6 via le câble 18 en fonction d'un signal de température qui provient d'un capteur de température 60 et qui est acheminé via un câble 61 au circuit de pilotage interne 71 à la prise gigogne 32. Il est possible de prévoir plusieurs capteurs de température 60 disposés en différents endroits prédéterminés à l'intérieur du micro-ordinateur, chaque capteur 60 étant relié au circuit de pilotage de la prise gigogne 32 par l'intermédiaire d'un câble spécifique 61.

L'une des caractéristiques additionnelles du dispositif de la présente invention réside dans le fait que les capteurs de température 60 sont de préférence disposés à une courte distance de composants électroniques particuliers 62 qui sont choisis comme étant des composants susceptibles de chauffer exagérément. Le composant électronique susceptible de chauffer 62 peut être l'un des composants électroniques d'une des cartes électroniques 3 prévues initialement dans le micro-ordinateur 1 ou peut être également un appareillage électrique ou électronique quelconque contenu initialement dans le micro-ordinateur 1. Cependant, ce composant électronique susceptible de chauffer 62 peut également être un composant particulier présent sur une carte électronique supplémentaire destinée à être rajoutée ultérieurement dans l'ordinateur en étant connectée aux connecteurs supplémentaires prévus à cet usage 14. Le circuit de pilotage 71 de la prise gigogne 32 est prévu de façon à commander le circuit de modulation d'alimentation 72 du moteur de ventilateur 6 en fonction d'une valeur de signal représentative de la température captée par le (ou les) capteurs de température 60.

Selon une première variante, la prise gigogne 32 peut commander en tout ou rien ou en tout ou peu le moteur de ventilateur 6 selon que la température captée est supérieure ou inférieure à un seuil prédéterminé. Selon une autre variante, la prise gigogne 32 peut en outre émettre un signal lumineux ou sonore constituant une alarme lorsque la température captée dépasse ce même seuil prédéterminé ou dépasse un autre seuil prédéterminé. Encore selon une autre variante, la prise gigogne 32 peut commander une tension d'alimentation du moteur de ventilateur 6 de telle sorte qu'elle soit une loi mathématique prédéterminée ou ajustable, linéaire ou non linéaire, de la valeur de signal représentative de la température captée par le (ou les) capteur(s) de température 60 disposé en un endroit prédéterminé de l'intérieur du micro-ordinateur.

Par conséquent, la prise gigogne 32 ainsi que les différents capteurs 60 raccordés à elle constituent ensemble un système qui permet à la fois de réduire partiellement le niveau sonore du micro-ordinateur 1, au moins pendant la plus grande partie de son temps de fonctionnement, et de constituer un système permettant de réguler le niveau de refroidissement du micro-ordinateur non pas en fonction de la température générale interne du micro-ordinateur mais en fonction de la température qui règne en des points particuliers prédéterminés de ce micro-ordinateur, ces points particuliers pouvant être choisis d'une façon différente en fonction des différentes cartes électroniques rajoutées ultérieurement dans le micro-ordinateur. Ceci permet d'augmenter la fiabilité du fonctionnement du micro-ordinateur lorsque sa configuration est modifiée par une personne quelconque intervenant postérieurement à sa fabrication, par exemple un utilisateur, un revendeur ou une personne chargée de sa maintenance.

La figure 4 représente une variante de réalisation de la prise gigogne 31 dans laquelle le circuit de modulation d'alimentation 46 et le circuit de pilotage 48 sont dans un boîtier 70 séparé du boîtier 43 de la prise gigogne 31, le boîtier 70 étant relié au boîtier 43 par un câble incluant les connexions électriques 52 et 53 qui relient au boîtier 70 certains contacts mâles 44 et leurs contacts correspondants femelles 45. Cette construction permet de réduire l'encombrement du boîtier de la prise gigogne 31 si cela est nécessaire ou préférable.

De même, la figure 6 représente une variante de réalisation de la prise gigogne 32 dans laquelle le circuit de modulation d'alimentation 78 et le circuit de pilotage 71 sont dans un boîtier 78 séparé du boîtier 79 de la prise gigogne 32, le boîtier 78 étant relié au boîtier 79 par un câble incluant les connexions électriques 73 et 76 qui relient au boîtier 78 certains contacts femelles 23 et leurs contacts correspondants mâles 24. Cette construction permet de réduire l'encombrement du boîtier de la prise gigogne 32 si cela est nécessaire ou préférable. Sur cet exemple de réalisation décrit dans la figure 6 où il est possible d'accueillir quatre capteurs de température 60, on a accueilli seulement trois capteurs de température 60 reliés via les trois câbles 61, les trois connecteurs femelles 61C, le connecteur mâle 81 et les conducteurs 61A au circuit de pilotage 71. On asservit ainsi le niveau de refroidissement du micro-ordinateur en fonction des trois températures des trois capteurs de température 60. Par ailleurs, on voit sur la figure 6 que la prise gigogne 32 est reliée de manière amovible, via un connecteur femelle 80, au boîtier 78, ce qui permet de connecter une pluralité de types de connecteurs 19 et 20 via une pluralité de prises gigogne 32 au même boîtier 78. On peut également utiliser un dispositif identique pour la prise gigogne 31.

Un second mode de réalisation peut être celui où l'unité de type 1 et l'unité de type 2 se présentent sous la forme d'un circuit (non représenté) s'insérant respectivement sur les câbles 15 et 18 qui ont été totalement ou partiellement sectionnés, ce circuit ne comportant pas nécessairement de connecteurs tels que ceux destinés à accueillir respectivement les connecteurs 16/17 et 19/20 présents dans le micro-ordinateur, mais comportant plus généralement des contacts d'entrée et de sortie qui sont conçus de façon classique pour pouvoir se raccorder aux fils électriques des câbles 15 et 18.

Dans ce second mode de réalisation, les unités de type 1 et de type 2 ont une structure et un fonctionnement identiques à la structure et au fonctionnement des unités de type 1 et de type 2 décrits dans le premier mode de réalisation. Dans ce second mode de réalisation où l'unité de type 1 et l'unité de type 2 se présentent sous la forme d'un circuit s'insérant sur câble, on peut soit sectionner un seul des deux fils d'alimentation des câbles 15 ou 18 et prélever un courant sur le second via un contact "vampire" ou auto-dénudant réalisant une perforation à travers l'isolant du fil pour établir un contact électrique sans sectionner le conducteur de ce second fil, soit sectionner les deux fils d'alimentation des câbles 15 ou 18. Les contacts électriques entre les fils des câbles et le circuit d'insertion sur câble peuvent être effectués par des méthodes classiques telles que : des connecteurs, des borniers à vis, des connecteurs auto-dénudants, des soudures, des sertissages, des bornes auto-grippantes sur conducteur dénudé, etc.

D'autres modes de réalisation peuvent être ceux qui combinent pour les n unités de type 1 et p unités de type 2 (n>1 et p≥1) des réalisations soit sous la forme de prise gigogne, soit sous la forme de circuit d'insertion sur câble pour chaque unité.

Une autre particularité de la présente invention consiste à monter le capteur de température en un endroit spécifique déterminé de la manière suivante. Le principe général de cette détermination d'endroit spécifique consiste à spécifier que le capteur doit mesurer la température d'un air qui vient de l'extérieur et qui a en outre déjà été partiellement réchauffé par des éléments internes du micro-ordinateur. Ce réchauffement partiel correspond à la formule suivante :

$$Tmes = Tent + k \, (Tsort - Tent)$$

où

Tmes est la température mesurée lors d'un fonctionnement normal du micro-ordinateur,
Tent est la température d'entrée lors d'un fonctionnement normal du micro-ordinateur,
Tsort est la température de sortie lors d'un fonctionnement normal du micro-ordinateur,
k est une constante prédéterminée comprise entre 0,1 et 0,5.

En opérant de la façon ainsi spécifiée, il se produit un phénomène d'anticipation dans le déclenchement du ventilateur dans le cas où un échauffement anormal d'un composant interne a pour cause une température d'air d'entrée trop haute, et il se produit également un autre phénomène de prise en compte directe de la quantité de chaleur produite dans l'ensemble de la machine.

L'invention n'est pas limitée aux modes de réalisation qui viennent d'être décrits mais elle s'étend aux variantes et modifications résultant de dispositions particulières dans la construction des ordinateurs. En particulier, le câble 15 n'est pas nécessairement un câble mais est souvent constitué par la juxtaposition de quatre fils indépendants reliés au même connecteur. D'une façon similaire, le câble 18 n'est pas nécessairement un câble mais est souvent constitué par la juxtaposition de deux fils indépendants reliés au moteur de ventilateur. Par ailleurs, les circuits de modulation d'alimentation 46 et 72 peuvent très bien ne commander que l'ouverture/fermeture d'un seul circuit (en agissant en un point sur la boucle de courant).

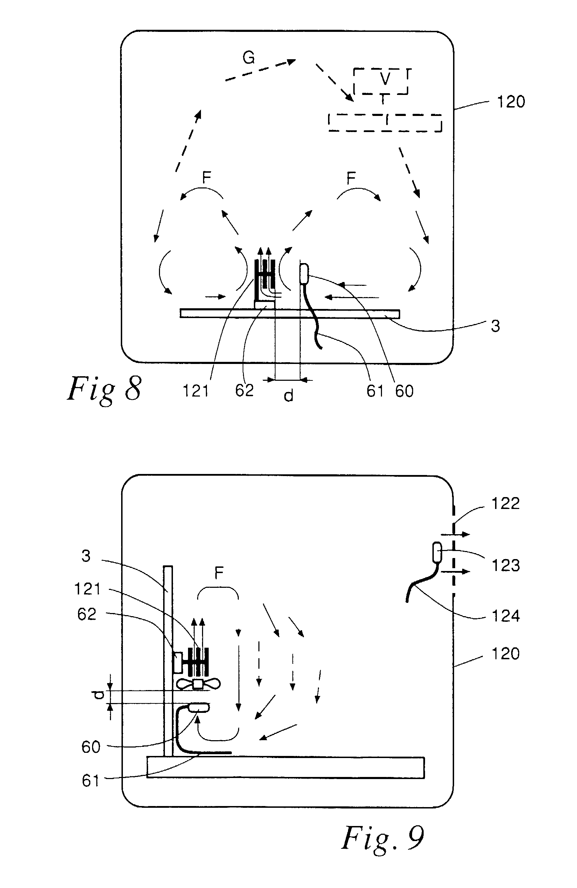

Sur les figures 8 et 9, on a représenté l'intérieur d'un micro-ordinateur, de façon à montrer des emplacements de capteurs de température, emplacements déterminés selon un autre aspect de la présente invention. Sur la figure 8, on distingue un boîtier externe de micro-ordinateur 120 incluant une carte électronique 3 disposée horizontalement, sur laquelle est disposé un composant 62 susceptible de chauffer anormalement et muni d'un radiateur 121. Le composant est refroidi par convection naturelle (figures F) ou, selon une variante, par une circulation d'air forcée obtenue par un ventilateur V relativement éloigné du composant 62 (par exemple éloigné de plus de 3 cm (ventilateur V représenté en pointillés provoquant une circulation d'air représentée par des flèches en pointillés G). Dans tous ces cas, selon un autre aspect de la présente invention, il est prévu de disposer le capteur 60 en amont du composant 62 ou de son radiateur 121, par rapport à la direction d'écoulement d'air de refroidissement arrivant sur le composant 62 (ou son radiateur 121), et à une distance "d" du composant 62 (ou son radiateur 121) comprise entre 2 mm et 25 mm, de préférence entre 5 mm et 20 mm. De nombreuses expérimentations ont été menées par l'inventeur et elles ont conduit à cette spécification qui s'explique de la façon suivante. Le capteur 62 détecte ainsi la température de l'air qui vient refroidir le composant mais en un endroit où cet air a déjà subi un certain réchauffement à court terme dû directement au composant (du fait de la relativement faible distance "d"). Ce réchauffement partiel à court terme ou rapide peut être dû, d'après nos analyses, à certains mouvements parasites de l'air à proximité du composant et/ou à un effet direct de rayonnement infra-rouge du composant ou de son radiateur.

Sur la figure 9, la carte 3 est disposée verticalement, bien que cela ne soit pas indispensable. En outre, le radiateur 121 du composant 62 est refroidi par un micro-ventilateur de proximité V2 qui est situé à moins de 10 mm du radiateur. Dans ce cas, la distance "d" préconisée selon notre invention est mesurée entre l'extrémité amont du ventilateur V2 et le capteur 60. Cette distance "d" est dans ce cas comprise entre 0 et 20 mm, de préférence entre 0 et 10 mm. Le capteur 60 est toujours situé en amont du radiateur 121 ou du composant 62, par rapport à la direction de déplacement de l'air de refroidissement arrivant sur le radiateur ou le composant. En outre, il est prévu un autre capteur 123 qui mesure un air sortant du micro-ordinateur et par conséquent un air qui a été réchauffé globalement et de manière moyennée dans l'espace et dans le temps par un grand nombre de sources chaudes internes au micro-ordinateur. Dans ce cas, un ventilateur est commandé de façon à augmenter sa vitesse si l'un ou l'autre des capteurs 60 et 123 (ou les deux simultanément) dépasse(nt) son(leur) seuil de température prédéterminé respectif. Après de nombreuses expérimentation menées par l'inventeur, ce mode de commande de ventilateur permet de limiter au maximum les nuisances sonores sans toutefois prendre un quelconque risque de dépassement de température d'un composant.

Sur la figure 10, on distingue un autre mode de réalisation préféré de l'invention. Une unité remplissant la même fonction que l'unité 31 ou 32 décrite précédemment est conformée différemment comme décrit ci-après. L'unité comprend un boîtier 124 qui comporte un double connecteur femelle 126 (dont la fonction est décrite par la suite), un avertisseur 125 et deux autres connecteurs femelles 132, 133 (dont la fonction est décrite par la suite). Le boîtier inclut toutes les fonctions électroniques de commande (de ventilateur ou de disque) telles que décrites précédemment en relation avec les unités 31 ou 32. La différence réside dans le mode de connexion du boîtier 124 avec les autres éléments du micro-ordinateur. Ici, le connecteur femelle 19 (figure 2) est connecté à un connecteur mâle 129 qui est raccordé au boîtier 124 via un câble 128 et un double connecteur femelle 127 lui-même branché sur le double connecteur mâle 126. Le connecteur mâle 20 (figure 2) est connecté à un connecteur mâle 131 qui est raccordé au boîtier 124 via un câble 1130 et le double connecteur femelle 127 lui-même branché sur le double connecteur mâle 126. L'alimentation électrique arrivant par 20 alimente l'électronique de commande incluse dans le boîtier 124 via 131, 130, 127 et 126, puis l'énergie électrique est envoyée de façon modulée par cette électronique au connecteur 19 d'un moteur de ventilateur 6 (figure 2) via 126, 127, 128 et 129. En outre, des capteurs 60 (figure 2) et 122 (figure 8) sont connectés à l'électronique incluse dans le boîtier 124 via des câbles 61, 123, des connecteurs femelles 134, 135 et des connecteurs mâles respectifs 132, 133 montés sur le boîtier 124. De cette façon, on peut disposer le boîtier 124 en un endroit quelconque interne du micro-ordinateur.

**Revendications**

1. Dispositif pour réduire le niveau sonore d'un micro-ordinateur, incluant: au moins un ventilateur (5) entraîné en rotation par un moteur de ventilateur, au moins un composant (62) dégageant de la chaleur selon une puissance calorifique que varie en fonction des conditions de fonctionnement du composant, une première source d'alimentation (4) pour alimenter en courant électrique le moteur de ventilateur, un premier câble électrique (18) reliant la première source d'alimentation au moteur de ventilateur, le dispositif comprenant :

   - au moins une unité de premier type (32) incluant des contacts d'entrée et de sortie, et étant connectée de façon intercalaire et amovible sur le premier câble (18) entre un premier élément de connexion (19) et un second élément de connexion (20) et qui inclut :

     - un premier circuit de modulation d'alimentation (72) commandé en fonction d'un signal de commande de façon à couper, établir ou moduler de façon sélective l'alimentation du moteur de ventilateur via certains contacts d'entrée et de sortie de l'unité de premier type, et
     - un premier circuit de pilotage (71) qui est alimenté en permanence par la première alimentation via les contacts d'entrée de l'unité de premier type qui reçoit, via au moins un câble (61), au moins un signal de température produit par au moins un capteur (60) situé à une certaine distance dudit au moins un composant dégageant de la chaleur, et qui produit en sortie ledit signal de commande destiné à commander le premier circuit de modulation,

   - ledit au moins un capteur de température destiné à ladite unité de premier type étant installé dans ledit micro-ordinateur.

2. Dispositif selon la revendication 1, dans lequel ledit au moins premier capteur de température est positionné en amont dudit au moins composant dégageant de la chaleur, par rapport à la direction d'écoulement, obtenu par convection naturelle ou par ventilation forcée de non proximité, d'un air de refroidissement du composant, la distance séparant ledit premier capteur et ledit composant étant comprise entre 5 mm et 20 mm.

3. Dispositif selon la revendication 1, dans lequel ledit au moins premier capteur de température est positionné en amont dudit au moins composant dégageant de la chaleur, par rapport à la direction d'écoulement, obtenu par ventilation forcée, provoquée par un ventilateur de proximité agencé spécifiquement pour ce composant et situé très près de lui, d'un air de refroidissement du composant, la distance séparant ledit premier capteur et ledit ventilateur de proximité étant comprise entre 0 mm et 10 mm.

4. Dispositif selon la revendication 1 ou 2, dans lequel un autre capteur de température est positionné dans le flux d'un air de refroidissement à l'endroit où cet air sort du micro-ordinateur et donc après avoir été réchauffé du fait de l'apport de chaleur cumulé de cet ensemble de composants.

5. Dispositif selon l'une quelconque des revendications 1 à 4, dans lequel ledit micro-ordinateur inclut en outre, entre autre au moins un disque (2) entraîné en rotation par un moteur, au moins un circuit électrique (3) comportant au moins une borne de sortie produisant un signal de requête de fonctionnement du disque, une seconde source d'alimentation pour alimenter en courant électrique le moteur de disque, un deuxième câble électrique (15) reliant la seconde source d'alimentation au moteur de disque,

le dispositif comprenant :

- au moins une unité de second type (31) incluant des contacts d'entrée et de sortie, qui est destinée à pouvoir se connecter de façon intercalaire et amovible sur le deuxième câble électrique (15) entre un troisième élément de connexion (16) et un quatrième élément de connexion (17) et qui inclut :

  - un second circuit de modulation d'alimentation (46) commandé en fonction d'un signal de commande de façon à couper, établir ou moduler de façon sélective l'alimentation électrique pour le moteur de disque via certains contacts d'entrée et de sortie de l'unité de second type ; et
  - un second circuit de pilotage (48) qui est alimenté en permanence par la seconde alimentation via les contacts d'entrée de l'unité de second type (31), qui reçoit ledit signal de requête de fonctionnement via un troisième câble (50) et qui produit en sortie ledit signal de commande pour commander le second circuit de modulation d'alimentation (46).

6. Dispositif selon la revendication 5, dans lequel ledit second circuit de pilotage (48) reçoit ledit signal de requête de fonctionnement via ledit troisième câble (50) et via un connecteur (56) connectable à un élément de connexion (10, 11) existant initialement dans le micro-ordinateur.

7. Dispositif selon la revendication 5, dans lequel ladite unité de second type (31) et ladite unité de premier type (32) sont disposées chacune en au moins un exemplaire dans un emballage unique afin de constituer ledit dispositif sous forme d'un kit destiné à être utilisé pour réduire le niveau sonore d'un micro-ordinateur.

8. Dispositif selon la revendication 7, dans lequel ladite unité de second type (31) ou sa connectique est disposée en une pluralité d'exemplaires dans ledit emballage unique, ces exemplaires différant les uns des autres par la forme desdits contacts d'entrée et de sortie de façon à ce que cette pluralité d'exemplaires couvre une pluralité de types standards différents possibles pour lesdits troisième et quatrième éléments de connexion.

9. Dispositif selon la revendication 7, dans lequel ladite unité de premier type (32) ou sa connectique est disposée en une pluralité d'exemplaires dans ledit emballage unique, ces exemplaires différant les uns des autres par la forme desdits contacts d'entrée et de sortie de façon à ce que cette pluralité d'exemplaires couvre une pluralité de types standards différents possibles pour lesdits premier et deuxième éléments de connexion.

10. Procédé pour réduire le niveau sonore d'un micro-ordinateur incluant au moins un ventilateur (5) entraîné en rotation par un moteur de ventilateur, au moins un composant (62) dégageant de la chaleur selon une puissance calorifique qui varie en fonction des conditions de fonctionnement du composant, une première source d'alimentation (4) pour alimenter en courant électrique le moteur de ventilateur , un premier câble électrique (18) reliant la première source d'alimentation au moteur de ventilateur, le procédé comprenant les étapes suivantes :

- on connecte au moins une unité de premier type (32) incluant des contacts d'entrée et de sortie, de façon intercalaire et amovible sur le premier câble (18) entre un premier élément de connexion (19) et un second élément de connexion (20) et qui inclut un premier circuit de modulation d'alimentation (72) du moteur de ventilateur et un premier circuit de pilotage (71) de celui-ci qui est alimenté en permanence par la première alimentation via certains contacts d'entrée et de sortie de l'unité de premier type;
- on adresse audit circuit de pilotage (71) via au moins un câble (61), au moins un signal de température produit par au moins un capteur (60) situé à une certaine distance dudit au moins un composant dégageant de la chaleur, et qui produit en sortie un signal de commande destiné à commander ledit premier circuit de modulation d'alimentation (72) de façon à couper, établir ou moduler de façon selective l'alimentation du moteur de ventilateur via certains contacts d'entrée et de sortie de l'unité de premier type;
- on installe ledit au moins un capteur de température destiné à ladite unité de premier type dans ledit micro-ordinateur.

**11.** Procéde selon la revendication 10, dans lequel on commande ledit moteur de ventilateur de façon à augmenter sa vitesse lorsque ledit premier capteur détecte une température supérieure à un premier seuil prédéterminé ou lorsque un autre capteur disposé dans le flux d'un air de refroidissement à l'endroit où cet air sort du micro-ordinateur après avoir balayé un ensemble de composants du micro-ordinateur et donc après avoir été réchauffé du fait de l'apport de chaleur cumulé de cet ensemble de composants, détecte une température supérieure à un autre seuil prédéterminé, cette condition "ou" étant une fonction logique "ou inclusif".

**12.** Procédé selon l'une quelconque des revendications 10 ou 11, dans lequel ledit micro-ordinateur inclut en outre, au moins un disque (2) entraîné en rotation par un moteur de disque, au moins un circuit électrique (3) comportant au moins une borne de sortie produisant un signal de requête de fonctionnement du disque, une seconde source d'alimentation pour alimenter en courant électrique le moteur de disque, un deuxième câble électrique (15) reliant la seconde source d'alimentation au moteur de disque, le procédé comprenant les étapes supplémentaires suivantes :

- on connecte au moins une unité de second type (31) incluant des contacts d'entrée et de sortie, de façon intercalaire et amovible sur le deuxième câble électrique (15) entre un troisième élément de connexion (16) et un quatrième élément de connexion (17) et qui inclut un second circuit de modulation d'alimentation (46) et un second circuit de pilotage (48) de celui-ci qui est alimenté en permanence par la seconde source d'alimentation ;
- on adresse audit circuit de pilotage (48) un signal de requête de fonctionnement via un troisième câble (50) et qui produit en sortie un second signal de commande pour commander le second composant de modulation d'alimentation (46) de telle sorte que soit :

  - on alimente le moteur de disque pendant tout le temps où le signal de requête de fonctionnement est dans un état signifiant une requête de fonctionnement,
  - soit on provoque la coupure ou l'abaissement de l'alimentation du moteur de disque lorsque le signal de requête de fonctionnement est resté dans un état signifiant une absence de requête de fonctionnement pendant une durée dépassant une valeur prédéterminée, ajustable par l'utilisateur, ou automatiquement ajustable.

**13.** Procédé suivant l'une quelconque des revendications 10 à 12, dans lequel

- on sectionne totalement ou partiellement le premier câble électrique (18) et/ou le deuxième câble électrique (15), respectivement du ventilateur (5) et du disque (2),
- on branche de façon intercalaire et amovible entre les deux extrémités sectionnées de chacun de ces câbles respectivement par les premier et second éléments de connexion (19, 20) l'unité de premier type (32) et/ou par le troisième et quatrième élément de connexion (16, 17) l'unité de deuxième type (31).

**14.** Procédé suivant l'une quelconque des revendications 10 à 12, pour réduire le niveau sonore d'un micro-ordinateur dans lequel l'un ou les deux premier et deuxième câbles électrique (18,15) du moteur de ventilation (5) et du disque dur (2), comporte chacun au moins une paire d'éléments de connexion enfichables entre eux de façon amovibles, et qu'on intercale et on branche sur lesdits éléments de connexion existants respectivement ceux (19, 20) de l'unité de premier type (32) et/ou ceux (16,17) d'autre part de l'unité de deuxième type (31).

**Patentansprüche**

**1.** Vorrichtung zum Reduzieren des akustischen Pegels eines Mikrorechners, der umfaßt: mindestens einen Ventilator (5), der durch einen Ventilatormotor in Drehung versetzt wird, mindestens eine Komponente (62), die gemäß einer Wärmeleistung, die in Abhängigkeit von den Funktionsbedingungen der Komponente variiert, Wärme abgibt, eine erste Versorgungsquelle (4), um den Ventilatormotor mit elektrischem Strom zu versorgen, und ein erstes elektrisches Kabel (18), das die erste Versorgungsquelle mit dem Ventilatormotor verbindet, wobei die Vorrichtung umfaßt:

- wenigstens eine Einheit (32) von einem ersten Typ mit Eingangs- und Ausgangskontakten, die als herausnehmbarer Zwischenstecker (18) zwischen einem ersten Verbindungselement (19) und einem zweiten Verbindungselement (20) mit dem ersten Kabel verbunden ist, und die enthält:
- einen ersten Schaltkreis (72) zur Modulation der Stromversorgung, der in Abhängigkeit von einem Steuersignal derart gesteuert ist, daß die Stromversorgung des Ventilatormotors über bestimmte Eingangs- und Ausgangskontakte der Einheit vom ersten Typ selektiv unterbrochen, aufgebaut oder moduliert werden kann, und

- einen ersten Steuerschaltkreis (71), der durchgehend durch die erste Versorgung über die Eingangskontakte der Einheit vom ersten Typ versorgt wird, der über wenigstens ein Kabel (61) wenigstens ein Temperatursignal von wenigstens einem Meßfühler (60) in einem vorgegebenen Abstand von der wenigstens einen wärmeabgebenden Komponente empfängt und der am Ausgang das Steuersignal zum Steuern des ersten Modulationsschaltkreises erzeugt,

- wobei wenigstens ein Temperaturmeßfühler, der zu der Einheit vom ersten Typ gehört, in den Mikrorechner eingebaut ist.

2. Vorrichtung nach Anspruch 1, bei welcher der wenigstens erste Temperaturmeßfühler oberhalb der wenigstens einen wärmeabgebenden Komponente in Bezug auf den Strom, der sich durch natürliche Konvektion oder durch Ventilation aus der Entfernung ergibt, von Luft zum Kühlen der Komponente angeordnet ist, wobei der Abstand zwischen dem ersten Meßfühler und der Komponente zwischen 5 mm und 20 mm beträgt.

3. Vorrichtung nach Anspruch 1, bei welcher der wenigstens erste Temperaturmeßfühler oberhalb wenigstens der wärmeabgebenden Komponente in Bezug auf den Strom, der sich durch Ventilation ergibt, die hervorgerufen wird durch einen benachbarten Ventilator, der speziell für diese Komponente angetrieben wird und sich in großer Nähe zu dieser befindet, von Luft zum Kühlen der Komponente angeordnet ist, wobei der Abstand zwischen dem ersten Meßfühler und dem Ventilator in der Nähe zwischen 0 mm und 10 mm beträgt.

4. Vorrichtung nach Anspruch 1 oder 2, bei welcher ein weiterer Temperaturmeßfühler in dem Luftstrom zum Kühlen an dem Ort angeordnet ist, wo diese Luft den Mikrorechner verläßt und daher aufgeheizt ist aufgrund des Beitrags der gestauten Wärme der Gruppe von Komponenten.

5. Vorrichtung nach einem der Ansprüche 1 bis 4, bei welcher der Mikrorechner außerdem unter anderem wenigstens eine Platte (2), die durch einen Motor in Drehung versetzt wird, wenigstens einen elektrischen Schaltkreis (3), der wenigstens einen Ausgangsanschluß umfaßt und ein Signal zur Abfrage der Funktion der Platte erzeugt, eine zweite Versorgungsquelle zum Versorgen mit elektrischem Strom des Motors der Platte, ein zweites elektrisches Kabel (15), das die zweite Versorgungsquelle mit dem Motor der Platte verbindet, umfaßt, wobei die Vorrichtung umfaßt:

- wenigstens eine Einheit von einem zweiten Typ (31) mit Eingangs- und Ausgangskontakten, die dazu dient, als Einschub und herausnehmbar mit dem zweiten elektrischen Kabel (15) zwischen einem dritten Verbindungselement (16) und einem vierten Verbindungselement (17) verbunden zu werden, und die beinhaltet:

- einen zweiten Schaltkreis zum Modulieren der Versorgung (46), gesteuert in Abhängigkeit von einem Steuersignal, derart daß die elektrische Versorgung für den Motor der Platte über vorgegebene Eingangs- und Ausgangskontakte der Einheit vom zweiten Typ unterbrochen, aufgebaut oder moduliert werden können, und

- einen zweiten Steuerschaltkreis (48), der durchgehend durch die zweite Versorgung über die Eingangskontakte der Einheit vom zweiten Typ (31) versorgt wird, der das Signal der Funktionsanfrage über ein drittes Kabel (50) empfängt und der am Ausgang das Steuersignal zum Ansteuern des zweiten Schaltkreises zum Modulieren der Versorgung (46) erzeugt.

6. Vorrichtung nach Anspruch 5, bei welcher der zweite Steuerschaltkreis (48) das Signal der Funktionsanfrage über das dritte Kabel (50) und über einen Verbinder (56), der mit einem Verbindungselement (10, 11) verbunden werden kann, das ursprünglich in dem Mikrorechner existiert, empfängt.

7. Vorrichtung nach Anspruch 5, bei welcher die Einheit vom zweiten Typ (31) und die Einheit vom ersten Typ (32) jeweils in wenigstens einer Ausführung in einer eindeutigen Verpackung vorgesehen ist, um die Vorrichtung in Form eines Baukastens zu bilden, der zum Verringern des akustischen Pegels eines Mikrorechners verwendet werden soll.

8. Vorrichtung nach Anspruch 7, bei welcher die Einheit vom zweiten Typ (31) oder sein Anschluß in mehreren Exemplaren in der eindeutigen Verpackung vorhanden sind, wobei diese Exemplare sich untereinander unterscheiden in der Form der Eingangs- und Ausgangskontakte, so daß diese mehreren Exemplare mehrere unterschiedliche Standardtypen für das dritte und vierte Verbindungselement abdecken.

9. Vorrichtung nach Anspruch 7, bei welcher die Einheit vom ersten Typ (32) oder ihr Anschluß in mehreren Exemplaren in der eindeutigen Verpackung vorgesehen sind, wobei diese Exemplare sich untereinander unterscheiden in der Form der Eingangs- und Ausgangskontakte, so daß diese mehreren Exemplare mehrere unterschiedliche Standardtypen bei dem ersten und zweiten Verbindungselement abdecken.

**10.** Verfahren zum Verringern des akustischen Pegels eines Mikrorechners mit wenigstens einem Ventilator (5), der in Drehung versetzt wird durch einen Ventilatormotor, wenigstens einer je nach Wärmeleistung wärmeabgebenden Komponente (62), die in Abhängigkeit von Funktionsbedingungen der Komponente variiert, einer ersten Versorgungsquelle (4) zum Versorgen mit elektrischem Strom des Ventilatormotors, einem ersten elektrischen Kabel (18), das die erste Versorgungsquelle mit dem Ventilatormotor verbindet, wobei das Verfahren die folgenden Schritte umfaßt:

- Verbinden wenigstens einer Einheit vom ersten Typ (32) mit Eingangs- und Ausgangskontakten als Einschub und herausnehmbar mit dem ersten Kabel (18) zwischen einem ersten Verbindungselement (19) und einem zweiten Verbindungselement (20), die außerdem einen ersten Schaltkreis zum Modulieren der Versorgung (72) des Ventilatormotors und einen ersten Steuerschaltkreis (71) für diesen umfaßt, welcher durchgehend durch die erste Versorgung über vorgegebene Eingangs- und Ausgangskontakte der Einheit vom ersten Typ versorgt wird,
- Adressieren an den Steuerschaltkreis (71) über wenigstens ein Kabel (61) wenigstens eines Temperatursignals von wenigstens einem Meßfühler (60) in einem vorgegebenen Abstand von wenigstens einer wärmeabgebenden Komponente, die außerdem am Ausgang ein Steuersignal zum Steuern des ersten Schaltkreises zum Modulieren der Versorgung (72) ausgibt, so daß selektiv die Versorgung des Ventilatormotors über vorgegebene Eingangs- und Ausgangskontakte der Einheit vom ersten Typ unterbrochen, aufgebaut und moduliert werden kann,
- Installieren des wenigstens einen Temperaturmeßfühlers für die Einheit vom ersten Typ in den Mikrorechner.

**11.** Verfahren nach Anspruch 10, bei welchem man den Ventilatormotor derart ansteuert, daß sich seine Geschwindigkeit erhöht, wenn der erste Meßfühler eine Temperatur erfaßt, die größer als eine erste vorgegebene Schwelle ist, oder wenn ein anderer Meßfühler, der in dem Strom der Luft zum Kühlen an dem Ort, wo die Luft den Mikrorechner verläßt, nachdem sie zuvor über eine Gruppe von Komponenten des Mikrorechners gestrichen ist und nachdem sie aufgeheizt wurde durch die angestaute Wärme von dieser Gruppe von Komponenten, angeordnet ist, eine Temperatur erfaßt, die größer als eine weitere vorgegebene Schwelle ist, wobei diese Bedingung "oder" eine logische Funktion "oder inklusive" ist.

**12.** Verfahren nach einem der Ansprüche 10 oder 11, bei welchem der Mikrorechner außerdem wenigstens eine Platte (2) umfaßt, die in Drehung durch einen Plattenmotor versetzt wird, wenigstens einen elektrischen Schaltkreis (3), der wenigstens einen Ausgangsanschluß umfaßt, der ein Signal zur Anfrage der Funktion der Platte erzeugt, eine zweite Versorgungsquelle, um mit elektrischem Strom den Plattenmotor zu versorgen, ein zweites elektrisches Kabel (15), das die zweite Versorgungsquelle mit dem Plattenmotor verbindet, wobei das Verfahren die folgenden zusätzlichen Schritte umfaßt:

- Verbinden wenigstens einer Einheit vom zweiten Typ (31) mit Eingangs- und Ausgangskontakten als Einschub und herausnehmbar mit dem zweiten elektrischen Kabel (15) zwischen einem dritten Verbindungselement (16) und einem vierten Verbindungselement (17), die auch einen zweiten Schaltkreis zum Modulieren der Versorgung (46) und einen zweiten Steuerschaltkreis (48) beinhaltet, von denen dieser durchgehend durch die zweite Versorgungsquelle versorgt wird,
- Adressieren an den Steuerschaltkreis (48) eines Signals zur Abfrage der Funktion über ein drittes Kabel (50), der am Ausgang ein zweites Steuersignal zum Steuern der zweiten Komponente zur Modulation der Versorgung (46) derart erzeugt, daß entweder:
- Versorgen des Plattenmotors während der gesamten Zeit, in der das Signal zur Abfrage der Funktion sich in einem Zustand befindet, der eine Abfrage zur Funktion anzeigt,

oder Unterbrechen oder Absenken der Versorgung des Plattenmotors, wenn das Signal zur Abfrage der Funktion in einem Zustand verbleibt, der die Abwesenheit einer Abfrage zur Funktion während einer Dauer über einem vorgegebenen Wert, einstellbar durch den Anwender oder automatisch einstellbar, anzeigt.

**13.** Verfahren nach einem der Ansprüche 10 bis 12, bei welchem

- ganz oder teilweise das erste elektrische Kabel (18) und/oder das zweite elektrische Kabel (15), bzw. der Ventilator (5) oder die Platte (2) ausgewählt wird,
- als Einschub und herausnehmbar zwischen die zwei ausgewählten Enden jedes dieser Kabel jeweils über das erste und zweite Verbindungselement (19, 20) die Einheit vom ersten Typ (32) und/oder durch das dritte oder vierte Verbindungselement (16, 17) die Einheit vom zweiten Typ (31) angeschlossen wird.

**14.** Verfahren nach einem der Ansprüche 10 bis 12 zum Verringern des akustischen Pegels eines Mikrorechners, bei dem entweder das erste oder zweite oder beide elektrischen Kabel (18, 15) des Motors für den Ventilator (5) und für die Festplatte (2) jeweils mit einem Paar von Elementen zum steckbaren Verbinden miteinander auf entfernbare Art und Weise versehen sind und bezüglich der existierenden Verbindungselemente die jeweiligen (19, 20) der Einheit vom ersten Typ (32) und/oder diejenigen (16, 17) des anderen Teils der Einheit vom zweiten Typ (31) eingeschoben und verbunden werden.

**Claims**

**1.** Device for reducing the sound level of a microcomputer, including at least one fan (5) rotated by a fan motor, at least one component (62) that gives off heat at a caloric power that varies as a function of the operating conditions of the component, a first power supply (4) for electrically powering the fan motor, a first electric cable (18) connecting the first power supply to the fan motor, the device comprising:

- at least one unit (32) of a first type including input and output contacts, suitable for being connected in releasable and interposed manner to the first cable (18) between a first connection element (19) and a second connection element (20) and which includes:

  - a first power supply modulation circuit (72) controlled as a function of a control signal so as to interrupt, establish, or modulate in selective manner the power supply to the fan motor via certian input and output contacts of the unit of the first type; and
  - a first control circuit (71) which is permanently powered by the first power supply via the input contacts of the unit of the first type, which receives, via at least one cable (61), at least one temperature signal produced by at least one sensor (60) situated at a certain distance from said at least one component that gives off heat, and which produces at the output said control signal for controlling the first modulation circuit,

- said at least one temperature sensor for said unit of the first type being installed in said microcomputer.

**2.** Device according to Claim 1, in which said at least first temperature sensor is positioned upstream from said at least one component that gives off heat in the flow direction obtained by natural convection or by non-proximity forced ventilation of air for cooling the component, the distance between said first sensor and said component being included between 5 mm and 20 mm.

**3.** Device according to Claim 1, in which said at least first temperature sensor is positioned upstream from said at least one component that gives off heat in the flow direction obtained by forced ventilation, caused by a proximity fan organized specifically for said component and situated very close thereto, of cooling air for the component, the distance between said first sensor and said proximity fan being included between 0 and 10 mm.

**4.** Device according to Claim 1 or 2, in which another temperature sensor is positioned in the flow of cooling air at the location where said air leaves the microcomputer and thus after being heated by receiving heat that has been accumulated by said set of components.

**5.** Device according to any one of preceding Claims 1 to 4, in which said microcomputer further includes, inter alia, at least one disk (2) rotated by a motor, at least one electrical circuit (3) including at least one output terminal producing a disk operation request signal, a second power supply for electrically powering the motor of the disk, a second electrical cable (15) connecting the second power supply to the disk motor, the device comprising:

- at least one unit (31) of a second type including input and output contacts suitable for being connected in releasable and interposed manner to the second electric cable (15) between a third connection element (16) and a fourth connection element (17) and which includes:

  - a second power supply modulation circuit (46) controlled as a function of a control signal so as to interrupt, establish, or modulate in selective manner the electrical power supply for the disk motor via certain input and output contacts of the unit of the second type; and
  - a second control circuit (48) which is permanently powered by the second power supply via the input contacts of the unit (31) of the second type, which receives said operation request signal via a third cable (50) and which outputs said control signal to control the second power supply modulation circuit (46).

**6.** Device according to Claim 5, in which said second control circuit (48) receives said operation request signal via said third cable (50) and via a connector (56) connectable to a connection element (10, 11) initially existing in the microcomputer.

7. Device according to Claim 5, in which said unit of the second type (31) and said unit of the first type (32) are each disposed in at least one model in a single package to constitute said device in the form of a kit designed to be used to reduce the sound level of a microcomputer.

8. Device according to Claim 7, in which said unit of the second type (31) or its set of connectors is disposed in a plurality of models in said single package, said models differing from one another by the configurations of said input and output contacts, whereby said plurality of models covers a plurality of different possible standard types of said third and fourth connection elements.

9. Device according to Claim 7, in which said unit of the first type (32) or its set of connectors is disposed in a plurality of models in said single package, said models differing from one another by the configurations of said input and output contacts, whereby said plurality of models covers a plurality of different possible standard types of said first and second connection elements.

10. Method for reducing the sound level of a microcomputer, the microcomputer including at least one fan (5) rotated by a fan motor, at least one component (62) that gives off heat at a caloric power that varies as a function of the operating conditions of the component, a first power supply (4) for electrically powering the fan motor, a first electric cable (18) connecting the first power supply to the fan motor connecting the first source of power supply to the fan motor;
the method comprising the following steps:

- connecting at least one unit (32) of a first type including input and output contacts, suitable for being connected in releasable and interposed manner to the first cable (18) between a first connection element (19) and a second connection element (20) and which includes a first power supply modulation circuit (72) of the fan motor and a first control circuit (71) which is permanently powered by the first power supply via certain input and output contacts of the unit of the first type;
- addressing to said control circuit (71) via at least one cable (61), at least one temperature signal produced by at least one sensor (60) located at a certain distance from said at least one component giving off heat, and which produces at the output a control signal intended to control said first power supply modulation circuit (72) so as to interrupt, establish or modulate in selective manner the power supply of the fan motor via certain input and output contacts of the unit of first type;
- installing said at least one temperature sensor intended for said unit of first type in said microcomputer.

11. Method according to Claim 10, in which said fan motor is controlled in such a manner as to increase its speed when said first sensor detects a temperature greater than a first predetermined threshold or when another sensor disposed in the flow of a cooling air at the location where this air emerges from the microcomputer after having swept a set of components of the microcomputer and therefore after having been heated due to the supply of heat accumulated in this set of components, detects a temperature greater than another predetermined threshold, this "OR" condition being a logical "inclusive-OR" function.

12. Method according to either one of Claims 10 or 11, in which said microcomputer further includes at least one disk (2) rotated by a disk motor, at least one electrical circuit (3) including at least one output terminal producing a disk operation request signal, a second power supply for electrically powering the motor of the disk, a second electrical cable (15) connecting the second power supply to the disk motor, the method comprising the following additional steps:

- connecting at least one unit (31) of second type including input and ouptut contacts suitable for being connected in releasable and interposed manner to the second electrical cable (15) between a third connection element (16) and a fourth connection element (17) and which includes a second power supply modulation circuit (46) and a second control circuit (48) therefor which is permanently powered by the second power supply source;
- addressing to said control circuit (48) an operation request signal via a third cable (50) and which produces at the output a second control signal for controlling the second power supply modulation component (46), with the result that either:

  . the disk motor is powered for the whole time that the operation request signal is in a state indicative of a request for operation,

  - or the interruption or reduction of the power supply of the disk motor is provoked when the operation request signal has remained in a state indicative of an absence of request for operation for a duration exceeding a predetermined value, adjustable by the user, or automatically adjustable.

13. Method according to any one of Claims 10 to 12, in which:

- the first electrical cable (18) and/or the second electrical cable (15) is totally or partially cut respectively from the fan (5) and the disk (2),
- there is connected in releasable and interposed manner between the two cut ends of each of these cables, respectively by the first and second connection elements (19, 20) the unit (32) of first type and/or, by the third and fourth connection element (16, 17), the unit (31) of second type.

14. Method according to any one of Claims 10 to 12, for reducing the sound level of a microcomputer, in which one or the two first and second electrical cables (18, 15) of the fan motor (5) and of the hard disk (2), each comprise at least one pair of connection elements fittable together in releasable manner, and there are interposed and connected on said existing connection elements respectively those (19, 20) of the unit (32) of first type and/or those (16, 17) on the other hand of the unit (31) of second type.

Fig. 1

Fig. 2

Fig. 10

Fig. 3

Fig. 4

Fig. 5

Fig. 6

```
                        ┌──────────┐
                        │  Début   │
                        └──────────┘
                             │
      ┌────────────────────────────────────────────────┐
 101  │ Le système d'exploitation décide d'effectuer    │
      │ une Entrée/Sortie sur un disque dur             │
      └────────────────────────────────────────────────┘
                             │
 102        ┌────────────────────────────────────┐
            │      Appel à une routine du BIOS    │
            └────────────────────────────────────┘
                             │
      ┌────────────────────────────────────────────────┐
 103  │ Initialisation du Crédit de tentative d'acès C  │
      └────────────────────────────────────────────────┘
                             │
 104  │ Emission d'une requête destinée au disque dur   │
      └────────────────────────────────────────────────┘
                             │
 105  │ Décrémentation du Crédit de tentative d'accès C │
      └────────────────────────────────────────────────┘
                             │
 106  oui ◁── Le disque dur répond positivement ──▷ non
                             │
 108  oui ◁── Le Crédit de tentative              ──▷ non
             d'accès C est-il ≥ 1 ?
                             │
 110  │ Poursuite de l'exécution lorsqu'un              │
      │ intervallede temps T                            │
      │ prédéterminé s'est écoulé                       │
      └────────────────────────────────────────────────┘
```

109

107 — Transfert des données entre le système d'exploitation et le disque dur

Une erreur d'accès au disque dur est signalée au système d'exploitation

```
                        ┌──────────┐
                        │   Fin    │
                        └──────────┘
```

C x T doit être supérieur au délai de mise en route du disque dur

*Fig. 7*

*Fig 8*

*Fig. 9*